(19) Europäisches Patentamt
European Patent Office
Office européen des brevets

(11) **EP 4 693 899 A1**

(12) **EUROPEAN PATENT APPLICATION**
published in accordance with Art. 153(4) EPC

(43) Date of publication:
**11.02.2026 Bulletin 2026/07**

(21) Application number: **23930964.4**

(22) Date of filing: **27.12.2023**

(51) International Patent Classification (IPC):
**H03G 3/20** (2006.01)  **G10L 21/034** (2013.01)
**H04B 3/23** (2006.01)

(52) Cooperative Patent Classification (CPC):
**G10L 21/034; H03G 3/20; H04B 3/23**

(86) International application number:
**PCT/JP2023/046903**

(87) International publication number:
**WO 2024/202349 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.03.2023 JP 2023050149**

(71) Applicant: **TRANSTRON INC.**
**Yokohama-shi, Kanagawa 222-0033 (JP)**

(72) Inventor: **SATOMI Yuki**
**Yokohama-shi, Kanagawa 222-0033 (JP)**

(74) Representative: **Winter, Brandl - Partnerschaft mbB**
**Alois-Steinecker-Straße 22**
**85354 Freising (DE)**

(54) **AUTOMATIC GAIN CONTROL DEVICE, ECHO REMOVAL DEVICE, AUTOMATIC GAIN CONTROL METHOD, AND AUTOMATIC GAIN CONTROL PROGRAM**

(57) To perform appropriate gain control while reducing the processing load of the processing unit. A frequency domain conversion unit configured to convert a first input signal of a time domain into a second input signal of a frequency domain, the first input signal being a reference signal that is input in a first time period from a reception-side signal path through which a received signal is transmitted to a speaker provided in a terminal; a gain determination unit configured to calculate a first gain based on the second input signal; and a gain multiplication unit provided in the reception-side signal path, and configured to multiply the received signal by the first gain are included. The reference signal is a signal after the received signal is multiplied by the first gain by the gain multiplication unit.

FIG. 2

EP 4 693 899 A1

**Description**

Technical Field

The present invention relates to an automatic gain control device, an echo removal device, an automatic gain control method, and an automatic gain control program.

Background Art

Patent Document 1 discloses an automatic gain control device that controls the gain at amplification of the input signal in accordance with the level of the input signal. This device includes: a noise detection unit configured to detect the degree of noise included in an input signal; a short time average level detection unit configured to detect a time average of the input signal in a relatively short time; a gain function selection unit configured to select any one gain function from among a plurality of gain functions prepared in advance in accordance with the degree of the noise detected by the noise detection unit; and a gain calculation unit configured to calculate a gain for amplifying the input signal from the short time average value of the input signal detected by the short time average level detection unit and the gain function selected by the gain function selection unit.

Citation List

Patent Document

Patent Document 1: JP 2004-129187 A

Summary of Invention

Technical Problem

In the invention described in Patent Document 1, obtaining the average value of the input signal imposes a load on the processing unit, thus requiring a CPU with high processing capability. Therefore, in the invention of Patent Document 1, it is not possible to perform appropriate gain control using a CPU with low processing capability.
In view of such circumstances, an object of the present invention is to provide an automatic gain control device, an echo removal device, an automatic gain control method and an automatic gain control program enabling appropriate gain control to be performed while reducing the processing load of the processing unit.

Solution to Problem

To solve the above-mentioned issues, an automatic gain control device according to the present invention includes: a frequency domain conversion unit configured to convert a first input signal of a time domain into a second input signal of a frequency domain, the first input signal being a reference signal that is input in a first time period from a reception-side signal path through which a received signal is transmitted to a speaker provided in a terminal; a gain determination unit configured to calculate a first gain based on the second input signal; and a gain multiplication unit provided in the reception-side signal path, and configured to multiply the received signal by the first gain. The reference signal is a signal after the received signal is multiplied by the first gain at the gain multiplication unit.
To solve the above-mentioned issues, an automatic gain control method according to the present invention includes: converting a first input signal of a time domain into a second input signal of a frequency domain, the first input signal being a reference signal that is input in a first time period from a reception-side signal path through which a received signal is transmitted to a speaker provided in a terminal; calculating a first gain based on the second input signal; and multiplying the received signal by the first gain, the multiplying being provided in the reception-side signal path. The reference signal is a signal after the received signal is multiplied by the first gain.
To solve the above-mentioned problems, an automatic gain control program according to the present invention is configured to cause a computer to function as: a frequency domain conversion unit configured to convert a first input signal of a time domain into a second input signal of a frequency domain, the first input signal being a reference signal that is input in a first time period from a reception-side signal path through which a received signal is transmitted to a speaker provided in a terminal; a gain determination unit configured to calculate a first gain based on the second input signal; and a gain multiplication unit provided in the reception-side signal path, and configured to multiply the received signal by the first gain. The reference signal is a signal after the received signal is multiplied by the first gain at the gain multiplication unit.
Note that the computer program can be provided by being downloaded via a network such as the Internet, or can be provided by being recorded in various computer-readable recording media such as a CD-ROM.

With the automatic gain control device, the automatic gain control method and the automatic gain control program according to the present invention, the first input signal, which is a received signal (reference signal) that is a signal multiplied by the first gain at the gain multiplication unit, is converted into the second input signal of the frequency domain, and the first gain is calculated on the basis of the second input signal. Since the process is performed for each first time period, the processing load of the processing unit can be reduced. In addition, by determining the first gain using the power of the reference signal, appropriate gain control can be performed.

The gain determination unit may include: an instantaneous power value acquisition unit configured to calculate an instantaneous power value based on the second input signal, the instantaneous power value being an instantaneous value of power of the reference signal; an average power estimation unit configured to calculate an average power of a numerical representation of an estimated value of a magnitude of sound that drives the speaker based on a plurality of the instantaneous power values determined by the instantaneous power value acquisition unit in a second time period that is longer than the first time period; a gain calculation unit configured to calculate a desired second gain based on the average power and a gain target value; and a discontinuity reduction unit configured to calculate the first gain based on the second gain, and set a rate of change of the first gain within a predetermined range. In this manner, by determining the first gain on the basis of the average power of the second time period, more appropriate gain control accurately reflecting the magnitude of the reference signal can be performed. In addition, the generation of abnormal noise due to the discontinuity of the signal caused by changes in gain can be reduced.

The gain determination unit may include: a second gain calculation unit configured to calculate a third gain for each frequency band based on the second input signal and a target value of a gain; an averaging unit configured to calculate a second gain by averaging, in a frequency direction and a time direction, the third gain calculated in a second time period that is longer than the first time period; and a discontinuity reduction unit configured to calculate the first gain based on the second gain, and set a rate of change of the first gain within a predetermined range. In this manner, by using the second gain, which is the average value of the gain obtained in the second time period, more appropriate gain control accurately reflecting the magnitude of the reference signal can be performed. In addition, the generation of abnormal noise due to the discontinuity of the signal caused by changes in gain can be reduced.

The discontinuity reduction unit may operate such that discontinuity of the first gain occurs at a zero-crossing point where an amplitude variation of the reference signal reverses. In this manner, at the zero-crossing point where the volume becomes zero, even a sudden change in gain is less likely to be perceived as unnatural by the user, and thus switching the gain at the zero-crossing point contributes to a more comfortable user experience.

The discontinuity reduction unit may gradually change the first gain in a range up to a maximum point where an amplitude variation of the reference signal is maximized. In this manner, reliably switching the gain before the time point at which the inappropriate multiplication of gain is likely to be perceived by the user contributes to a more comfortable user experience.

A power variation detection unit configured to detect that a rate of change of the instantaneous power value is equal to or greater than a predetermined value may be further provided, such that when the rate of change of the instantaneous power value is equal to or greater than the predetermined value is detected, the gain determination unit does not change the first gain. In this manner, by maintaining the previous gain during speech, unvoiced sounds, or sentence endings without changing the gain, audible voice can be ensured.

The gain determination unit may change the second gain over a third time period that is longer than the second time period. In this manner, abrupt changes in gain can be prevented.

When a magnitude of the received signal is equal to or greater than a threshold value, the gain multiplication unit may reduce the first gain. In this manner, clipping due to excessive amplification of the signal can be prevented. In addition, damage to the device can be prevented.

An echo removal device according to the present invention includes: the above-described automatic gain control device; and an echo removal unit provided in a transmission-side signal path through which an input signal input from a microphone provided in the terminal is transmitted, the echo removal unit being configured to remove echo that is generated when a voice output from the speaker is input to the microphone. The echo removal unit removes echo based on the second input signal converted by the frequency domain conversion unit. Specifically, the frequency domain conversion unit can be shared by the automatic gain control device and the echo removal unit. In this manner, it is possible to appropriately calculate the gain and remove echo with low processing cost.

Advantageous Effects of Invention

According to the present invention, appropriate gain control can be performed while reducing the processing load of the processing unit.

Brief Description of Drawings

FIG. 1 is a diagram schematically illustrating a voice communication system 100 provided with an echo removal device 1 according to a first embodiment.
FIG. 2 is a block diagram illustrating a schematic configuration of the echo removal device 1.
FIG. 3 is a schematic view for describing a process of an automatic gain control device 9.
FIG. 4 is a diagram illustrating an example of a weighting function.
FIG. 5 is a schematic view for describing the number of samples T1 and overlap ratio.
FIG. 6 is a diagram for describing another form of a discontinuity reduction unit 22d. FIG. 6A is a graph illustrating a reference signal. FIGS. 6B and 6C are graphs illustrating a gain.
FIG. 7 is a diagram for describing another form of the discontinuity reduction unit 22d. FIG. 7A is a graph illustrating a reference signal. FIG. 7B is a graph illustrating a gain.
FIG. 8 is a block diagram illustrating a schematic configuration of an echo removal device 2 according to a second embodiment.
FIG. 9 is a block diagram illustrating a schematic configuration of an echo removal device 3 according to a third embodiment.
FIG. 10 is a schematic view for describing a process of an automatic gain control device 9A.
FIG. 11 is a block diagram illustrating a schematic configuration of an echo removal device 4 according to a fourth embodiment.
FIG. 12 is a block diagram illustrating a schematic configuration of an echo removal device 5 according to a fifth embodiment.
FIG. 13 is a block diagram illustrating a schematic configuration of an echo removal device 6 according to a sixth embodiment.

Description of Embodiments

An automatic gain control device, an automatic gain control method and an automatic gain control program according to embodiments of the present invention are elaborated below with reference to the accompanying drawings.
The automatic gain control device is a device that automatically adjusts the gain of a signal. In the following embodiment, the automatic gain control device is provided in an echo removal device. The echo removal device is a device that suppresses echo generated during a call in a voice communication system.

First Embodiment

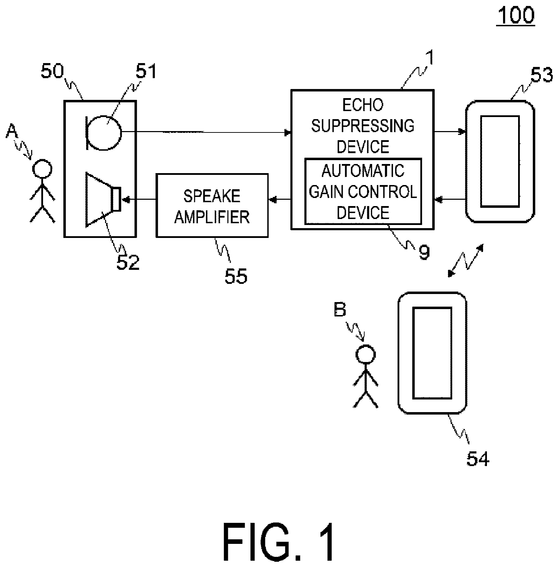

FIG. 1 is a diagram schematically illustrating the voice communication system 100 provided with the echo removal device 1 including the automatic gain control device 9 according to a first embodiment. The voice communication system 100 mainly includes a terminal 50 including a microphone 51 and a speaker 52, two communication devices 53 and 54, a speaker amplifier 55, and the echo removal device 1.
The voice communication system 100 is a system in which a near-end speaker (a user A located on the near-end side) using the terminal 50 (near-end terminal) performs voice communication with a user using the communication device 54 (far-end terminal) (a user B located on the far-end side). A voice signal (hereinafter referred to as received signal) input through the communication device 54 is loudly output with the speaker 52, and the voice emitted by the user A located on the near-end side is collected with the microphone 51 and transmitted to the communication device 54, and thus the user A can make a loudspeaker call (hands-free call) without grasping the communication device 53. The communication device 53 and the communication device 54 are connected through a common telephone line.
The echo removal device 1 and the automatic gain control device 9 may be configured as a dedicated board mounted in a communication terminal or the like (such as an in-vehicle device, a conference system, and a mobile terminal) in the voice communication system 100, for example. In addition, the echo removal device 1 may be composed of software (echo suppressing program) and a computer system mainly including a processing unit such as a CPU (central processing unit) for performing information processing and a storage device such as a RAM (random access memory) and a ROM (read only memory), for example. The echo suppressing program may be stored in advance in an SSD as a storage medium built in equipment such as a computer, a ROM in a microcomputer having a CPU, or the like, and installed in the computer from there. The echo suppressing program may be temporarily or permanently stored in a removable storage medium such as a semiconductor memory, a memory card, an optical disc, a magneto-optical disk, and a magnetic disk.

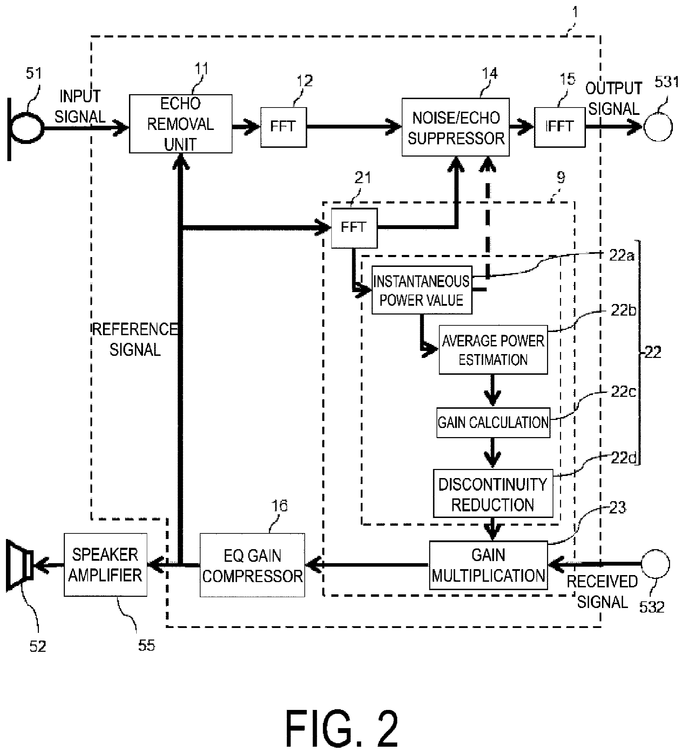

FIG. 2 is a block diagram illustrating a schematic configuration of the echo removal device 1 and the automatic gain control device 9. Functionally, the echo removal device 1 mainly includes the automatic gain control device 9, an echo removal unit 11, a frequency analyzer (FFT unit) 12, a noise/echo suppressor 14 (corresponding to the echo removal unit of the present invention), a restoration unit (IFFT unit) 15, and an EQ gain compressor 16. In FIG. 2, the signal path on the upper side is a transmission-side signal path through which an input signal input from the microphone 51 is transmitted, and the signal path on the lower side is a reception-side signal path through which a received signal is transmitted to the speaker 52. In addition, in the drawing, the arrow indicates a signal flow (process flow).

Note that, the functional components of the echo removal device 1 may be further divided into more components depending on the processing requirements, or a single component may perform the functions of multiple components.

The echo removal unit 11 removes echo by using an adaptive filter, for example. On the basis of reference signals, the echo removal unit 11 updates the filter coefficient in accordance with a given procedure, generates a pseudo-echo signal from the signal transmitted through the reception-side signal path, and subtracts the pseudo-echo signal from the input signal transmitted through the transmission-side signal path, thereby removing the echo. Here, the reference signal is a signal for driving the speaker 52, which is a signal after the received signal transmitted through the reception-side signal path is processed at a gain multiplication unit 23 (described in detail later) and the EQ gain compressor 16 (described in detail later). Note that, since adaptive filters are already well known, the explanation thereof is omitted.

Note that, while the adaptive filter is employed in the echo removal unit 11 in the present embodiment, other publicly known echo removal techniques may also be employed in the echo removal unit 11.

The frequency analyzer (FFT unit) 12 performs a Fast Fourier Transform (FFT) on the signal. The FFT unit 12 is a functional unit that performs frequency conversion in the process of the echo removal unit 11. The FFT unit 12 converts a sequential time-series signal (time domain) into a signal represented by a set of frequencies (frequency domain).

Note that, in the drawing, the FFT unit 12 and the FFT unit 21 are illustrated in different blocks for the sake of convenience of illustration, but the processes thereof may be performed by the same functional unit.

The noise/echo suppressor 14 is a functional unit that removes nonlinear echo that has not been removed by the echo removal unit 11 that removes linear echo, for example. The noise/echo suppressor 14 may perform a nonlinear echo suppressing process on the basis of instantaneous power values in addition to an appropriate frequency filter and the like, for example. The output value from the noise/echo suppressor 14 is subjected to an Inverse Fast Fourier Transform (IFFT) by the IFFT unit 15, and output as an output signal from an output unit 531 of the communication device 53.

Note that, while the FFT unit 12 performs a Fast Fourier Transform and the IFFT unit 15 performs an Inverse Fast Fourier Transform in the present embodiment, the processes performed by the FFT unit 12 and the IFFT unit 15 are not limited to this. For example, the FFT unit 12 may perform a Discrete Fourier transform (DFT), and the IFFT unit 15 may perform an Inverse Discrete Fourier Transform (IDFT).

The automatic gain control device 9 determines the gain on the basis of the received signal input from an input unit 532 and transmitted through the reception-side signal path, and multiplies the received signal by this gain. In the present embodiment, the gain is determined on the basis of the reference signal.

The received signal multiplied by the gain is output to the speaker amplifier 55 through the EQ gain (gain control or gain multiplication) compressor 16. The EQ gain compressor 16 includes an equalizer that suppresses the volume in a predetermined frequency band, and a compressor that compresses the dynamic range. Note that, the EQ gain compressor 16 is not an essential component. In that case, a signal obtained by performing a process on the received signal at the gain multiplication unit 23 (described in detail later) may be used as a reference signal.

Note that, the echo removal device 1 may have a configuration related to common speech detection and noise canceling. Since the processes of each configuration are already well known, the explanation thereof is omitted.

Next, the automatic gain control device 9 is described. Functionally, the automatic gain control device 9 mainly includes an FFT unit 21, a gain determination unit 22, and the gain multiplication unit 23. Functionally, the gain determination unit 22 mainly includes an instantaneous power value acquisition unit 22a, an average power estimation unit 22b, a gain calculation unit 22c, and a discontinuity reduction unit 22d. On the basis of the signal processed by the FFT unit 21, the gain determination unit 22 determines the gain (corresponding to the first gain of the present invention) that sets the level of the output signal within a certain range, and the received signal is multiplied by this gain at the gain multiplication unit 23.

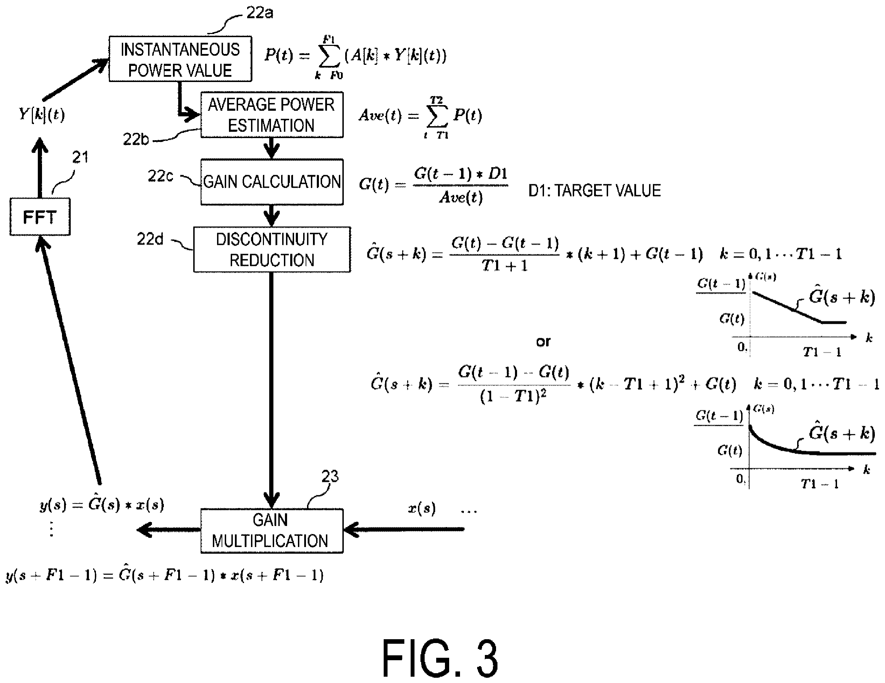

FIG. 3 is a schematic view for describing a process of the automatic gain control device 9. In the drawing, the arrow indicates a signal flow (process flow). Since the EQ gain compressor 16 is not an essential component, the process of the EQ gain compressor 16 is omitted in FIG. 3.

When x(s) represents a received signal obtained at the start of a time period ta (corresponding to the first time period of the present invention), a reference signal y(s) is expressed as in Expression (1). In addition, when x(s + F1 - 1) represents the last received signal obtained during the time period ta, a reference signal y(s + F1 - 1) is expressed as in Expression (2). Here, G(s) and G(s + F1 - 1) are the gain (corresponding to the first gain of the present invention) multiplied at the gain multiplication unit 23. F1 reference signals y(s) to y(s + F1 - 1) determined in this manner are input to the FFT unit 21.

[Equation 1]

$$y(s) = \hat{G}(s) * x(s)$$

$$\dots (1)$$

[Equation 2]

$$y(s + F1 - 1) = \hat{G}(s + F1 - 1) * x(s + F1 - 1)$$

$$\dots (2)$$

As with the FFT unit 12, the FFT unit 21 performs frequency conversion on the signal. The frequency conversion is a Fast Fourier Transform (FFT), for example. The FFT unit 21 performs the Fast Fourier Transform each time when the F1 (for example, 128) samples obtained in the time period ta are acquired. Through the above-described process, the FFT unit 21 determines the power spectrum as Y[k](t). Here, t represents the frame, and the first F1 samples are a first frame (t = 1), and the next F1 samples are a second frame (t = 2), for example. In addition, k represents the frequency band, and the number of k (frequency resolution) is the same as the number of samples F1. In this manner, the power spectrum Y[k](t) contains a mixture of frequency information (k) and time information (t).

The power spectrum Y[k](t) obtained by the FFT unit 21 (corresponding to the second input signal of the present invention) is input to the gain determination unit 22. The gain determination unit 22 (the instantaneous power value acquisition unit 22a, the average power estimation unit 22b, the gain calculation unit 22c, and the discontinuity reduction unit 22d) calculates the gain of the output signal such that the rate of change of the gain of the output signal has a predetermined value on the basis of the power spectrum Y[k](t) obtained by the FFT unit 21.

On the basis of the power spectrum Y[k](t), the instantaneous power value acquisition unit 22a calculates an instantaneous power value P(t), which is the instantaneous value of the power of the reference signal. More specifically, the instantaneous power value acquisition unit 22a calculates the instantaneous power value P(t) using Expression (3). Specifically, the instantaneous power value P(t) is the sum of the power of power spectra within the target frequency domain from F0 to F1.

[Equation 3]

$$P(t) = \sum_{k=F0}^{F1} (A[k] * Y[k](t))$$

$$\dots (3)$$

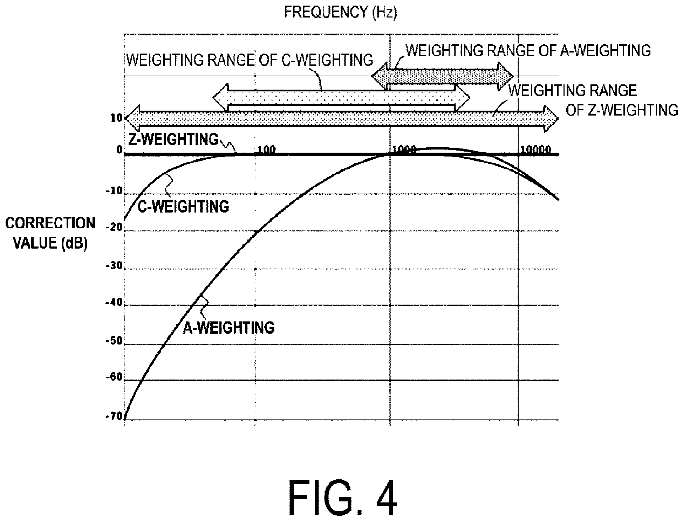

Note that, A[k] is a weighting function. FIG. 4 is a diagram illustrating an example of a weighting function. For example, the weighting function may be A-weighting; C-weighting; Z-weighting, which applies no weighting; and the like. By applying different weightings on the frequency band basis, the desired instantaneous power value P(t) can be obtained. For example, using A-weighting which attenuates low-frequency regions that are less audible to humans C-weighting and so on, allow the calculation of instantaneous power value P(t) that is more aligned with human auditory perception.

The instantaneous power value acquisition unit 22a determines the power spectrum Y[k](t) not for each time point, but for a predetermined number of samples F1 (the time period ta), thereby achieving low calculation frequency and reducing the processing cost.

The power spectrum obtained by the FFT unit 21 and the instantaneous power value obtained by the instantaneous power value acquisition unit 22a are input to the noise/echo suppressor 14. The noise/echo suppressor 14 suppresses nonlinear echo by using the instantaneous power value P(t). Note that, the FFT unit 21 and the instantaneous power value acquisition unit 22a may be provided in the noise/echo suppressor 14.

On the basis of a plurality of the instantaneous power values P(t) determined by the instantaneous power value acquisition unit 22a during a time period tb (corresponding to the second time period of the present invention) longer than the time period ta, the average power estimation unit 22b calculates an average power Ave(t), which is an average value of the instantaneous power values. The average power Ave(t) is a numerical representation of an estimated value of the volume of the sound output from the speaker 52 (see FIG. 2 and the like).

For example, the average power estimation unit 22b calculates the average power Ave(t) as the sum of the instantaneous power values P(t) over a certain period from T1 to T2 according to Expression (4). The time from T1 to T2 is the same as the time period tb.

[Equation 4]

$$Ave(t) = \frac{1}{T2 - T1} \sum_{t=T1}^{T2} P(t)$$

$$\dots (4)$$

For example, when it is assumed that the number of samples F1 is 128 and the sampling frequency is 16 kHz, the time period ta is a few milliseconds, and the instantaneous power value P(t) represents the power over a brief moment (a few milliseconds). Since the instantaneous power value P(t) fluctuates repeatedly, in the present embodiment, the average power Ave(t) is determined over a long period (time period tb) of e.g., about 1 to 3 seconds.

Note that, while the average power estimation unit 22b determines the sum of the instantaneous power values P(t) of the certain period from T1 to T2 as the average power Ave(t) above, the calculation method of the average power Ave(t) is not limited to this. For example, the average power estimation unit 22b may determine the average value of the instantaneous power values P(t) of the certain period from T1 to T2 as the average power Ave(t); a time-weighted average value (see Expression (5)) of the instantaneous power values P(t) of the certain period from T1 to T2 as the average power Ave(t); or the maximum value of the instantaneous power values P(t) of the certain period from T1 to T2 as the average power Ave(t). It should be noted that, calculating the average power Ave(t) using the average value is the most accurate method. On the other hand, calculating the average power Ave(t) using a time-weighted average value is the most efficient in terms of processing load.

[Equation 5]

$$Ave(t) = \alpha Ave(t - 1) + (1 - \alpha) \sum_{t=T1}^{T2} P(t)$$

$$\dots (5)$$

The gain calculation unit 22c calculates a gain G(t) (corresponding to the second gain of the present invention) on the basis of the average power Ave(t) and a gain target value D1. The gain calculation unit 22c determines the gain G(t) according to Expression (6), for example.

[Equation 6]

$$G(t) = \frac{G(t-1) * D1}{Ave(t)}$$

$$\dots (6)$$

In the present embodiment, the signal multiplied by the gain at the gain multiplication unit 23 is used for the calculation of the average power Ave(t), and therefore to eliminate it, the target value is multiplied by a gain G(t-1).

To reduce the discontinuity of the signal caused by changes in gain and smoothen the variation of signal, the discontinuity reduction unit 22d adjusts the G(t) obtained by the gain calculation unit 22c to determine the gain G(s + k) (corresponding to the first gain of the present invention). The discontinuity reduction unit 22d sets the rate of change of the gain G(s + k) within a predetermined range.

The gain calculation unit 22c determines the gain G(t) only once for every F1 samples, while received signals are continuously input. If the gain G(t) suddenly changes at this time, the discontinuity of the signal caused by changes in gain is generated, possibly generating abnormal noise. Therefore, the discontinuity reduction unit 22d sets the rate of change of the gain G(s + k) within a predetermined range to reduce the discontinuity of the signal.

The process of the discontinuity reduction unit 22d is performed according to Expression (7), for example. In Expression (7), the gain G(s + k) is the gain G(t - 1) of one previous frame when k = 0, and is the gain G(t) of the present frame when k = T1 - 1, and thus the gain G(s + k) linearly changes over given sample numbers k = 0 to T1 - 1. Note that, the number of samples T1 can be set in advance to, for example, 64 samples.

[Equation 7]

$$\hat{G}(s + k) = \frac{G(t) - G(t - 1)}{T1 - 1} * k + G(t - 1) \quad k = 0, 1 \cdots T1 - 1$$

$$\dots (7)$$

Note that, the process of the discontinuity reduction unit 22d is not limited to the process according to Expression (7), and may also be various processes with which signals before and after the gain change are smooth connected. For example, the discontinuity reduction unit 22d may adjust the gain G(s + k) according to Expression (8). In Expression (8), the signals before and after the gain change are connected by a curve (here, a secondary curve that has a minimum value at k = t - 1) over given sample numbers k = 0 to T1 - 1. In this manner, more smoother gain change can be achieved. [Equation 8]

$$\hat{G}(s+k) = \frac{G(t-1) - G(t)}{(1-T1)^2} * (k - T1 + 1)^2 + G(t) \quad k = 0, 1 \cdots T1 - 1$$

$$\cdots (8)$$

In Expressions (7) and (8), the gain is discontinuous at k = T1 - 1, while it changes continuously for k = 0 to T1 - 1. In this manner, by continuously changing the gain, the degree of the discontinuity of the gain at k= T1 - 1 is reduced, and the near-end speaker (the user A, see FIG. 1) can hear comfortable voice.

The gain multiplication unit 23 is provided in the reception-side signal path, and multiplies the received signal by the gain G(s + k).

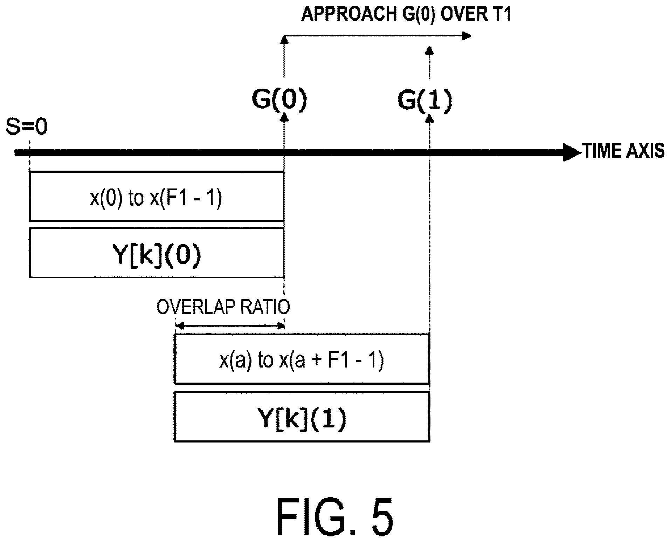

Note that, desirably the number of samples T1 is equal to or smaller than a value obtained by multiplying the number of samples F1 by a value obtained by subtracting the overlap ratio from 1 (T1 ≤ (1 - overlap ratio) * F1). The reason for this is described below with reference to FIG. 5. The abscissa of FIG. 5 indicates time axis.

In general, in the process at the FFT unit 21, the acquired data is divided into a plurality of frames (overlap process), and the FFT is performed after multiplying the divided frame by a window function. More specifically, as illustrated in FIG. 5, first, the FFT is performed on F1 received signals x(0) to x(F1 - 1) obtained after the time S = 0 to obtain a power spectrum Y[k](0), and a gain G(0) is determined on the basis of the power spectrum. Next, the FFT is performed on F1 received signals x(a) to x(a + F1 - 1) obtained after the time S = a to obtain a power spectrum Y[k](1), and a gain G(1) is determined on the basis of the power spectrum. The received signals x(0) to x(F1 - 1) for obtaining the power spectrum Y[k](0) and the received signals x(a) to x(a + F1 - 1) for obtaining power spectrum Y[k](1) partially overlap. The ratio of this overlap to the frame size is the overlap ratio.

Therefore, desirably, the number of frames T1 until completion of transition of the gain G(s + k) multiplied at the gain multiplication unit 23 from the gain G(t - 1) of one previous frame to the gain G(t) of the present frame is equal to or smaller than the number of frames until the gain G (t + 1)(G(1) in FIG. 5) of the next frame is obtained after the gain determination unit 22 acquires the gain G(t) (G(0) in FIG. 5) of the present frame, i.e., satisfies T1 ≤ (1 - overlap ratio) * F1.

According to the present embodiment, the automatic gain control device 9 performs the calculation for each fixed time period ta, and thus the processing load of the processing unit can be reduced. Therefore, gain control can be performed using a CPU with low processing performance. In addition, since the automatic gain control device 9 determines the gain G(s + k) using the reference signal power, appropriate gain control can be performed. In particular, since the gain G(s + k) is determined on the basis of the average power Ave(t) of the time period tb, i.e., the result appropriately reflecting the magnitude of the reference signal, more appropriate gain control can be performed.

In addition, in known automatic gain control typically performed, the gain multiplication unit 23 includes an FFT unit, and the gain is determined using the result after the Fourier transform, whereas in the present embodiment, the gain G(s + k) is determined using the reference signal, thereby the FFT unit in the gain multiplication unit 23 is unnecessary. Therefore, according to the present embodiment, gain control can be performed using a CPU with low processing performance.

In addition, according to the present embodiment, the noise/echo suppressor 14 removes echo on the basis of the power spectrum Y[k](t) obtained by the FFT unit 21, or more specifically, the noise/echo suppressor 14 suppresses nonlinear echo using the power spectrum Y[k](t) obtained by the FFT unit 21 and the instantaneous power value P(t) obtained by the instantaneous power value acquisition unit 22a, and thus it is not necessary for the noise/echo suppressor 14 to separately calculate the power spectrum Y[k](t) and the instantaneous power value P(t). In addition, the FFT unit 21 and the instantaneous power value acquisition unit 22a can be shared by the automatic gain control device 9 and the noise/echo suppressor 14. In this manner, the configuration of the noise/echo suppressor 14 can be effectively utilized to appropriately calculate the gain and remove echo with low processing cost.

Note that, in the present embodiment, the echo removal device 1 removes echo using the echo removal unit 11 and noise/echo suppressor 14, but an embodiment of removing echo is not limited to this. For example, the echo removal unit 11 is not an essential component. In addition, for example, in place of the noise/echo suppressor 14, the echo removal unit 11 may be provided at the position of the noise/echo suppressor 14. In this case, the echo removal unit 11 corresponds to the echo removal unit of the present invention. In addition, for example, the echo removal unit 11 may be eliminated such that the noise/echo suppressor 14 also serves a function of the echo removal unit 11.

In addition, for example, the noise/echo suppressor 14 may be provided between the FFT unit 21 and the instantaneous power value acquisition unit 22a. Since the calculation of the instantaneous power value P(t) becomes difficult when the reference signal contains noise, removing noise in advance from the reference signal to be input to the instantaneous power value acquisition unit 22a enables easier calculation.

In addition, in the present embodiment, the discontinuity reduction unit 22d changes the gain G(s + k) linearly or quadratically over a predetermined number of samples; however, the form of the process performed by the discontinuity reduction unit 22d is not limited to this.

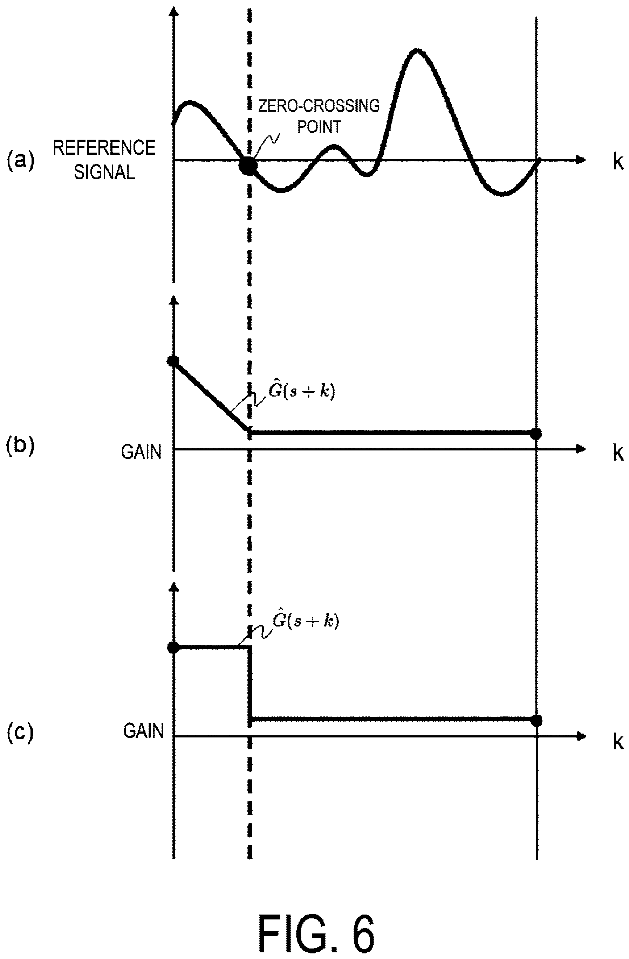

For example, the discontinuity reduction unit 22d may detect a zero-crossing point where the amplitude variation of the reference signal reverses as illustrated in FIG. 6A, and linearly or quadratically change the gain in the range up to the zero-crossing point period as illustrated in FIG. 6B. In addition, as illustrated in FIG. 6C, the discontinuity reduction unit 22d may change the gain at the zero-crossing point without changing the gain before the zero-crossing point. In this manner, the discontinuity reduction unit 22d changes the gain G(s + k) such that discontinuity occurs at the zero-crossing point. Since the volume becomes zero at the zero-crossing point, even a sudden change in gain is less likely to be perceived as unnatural by the user. Therefore, switching the gain at the zero-crossing point contributes to a more comfortable user experience. Note that, the zero-crossing point can be detected using any appropriate known method.

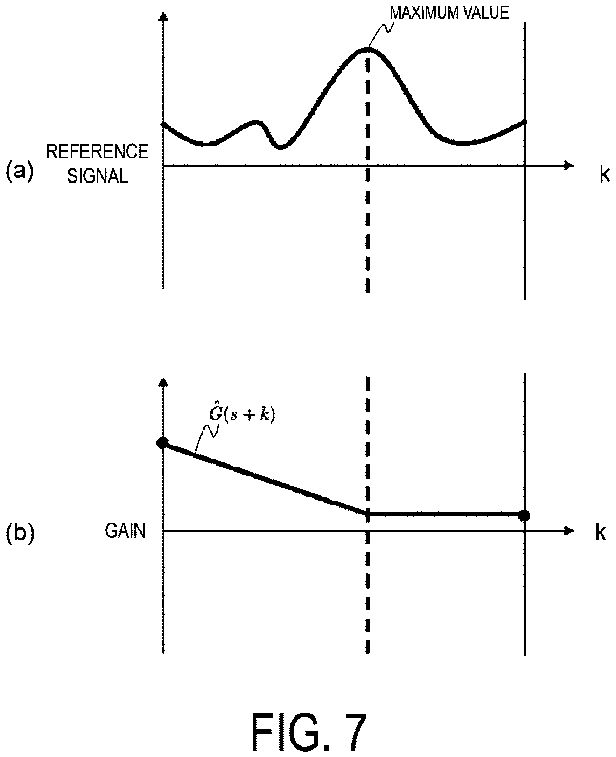

In addition, for example, the discontinuity reduction unit 22d may detect the maximum point where the amplitude variation of the reference signal is maximized as illustrated in FIG. 7A, and linearly or quadratically change the gain G(s + k) in the range up to the maximum point as illustrated in FIG. 7B. Since users are more likely to notice when an inappropriate gain has been applied at the time point when the signal is maximized, ensuring that the gain is switched by the time the signal is maximized contributes to a more comfortable user experience. The maximum point can be detected using any appropriate known method.

In addition, in the present embodiment, the number of frames T1 ≤ (1 - overlap ratio) * F1 is set, but T1 > (1 - overlap ratio) * F1 is not impossible. It should be noted that, in the case where T1 > (1 - overlap ratio) * F1 is set, G(t - 1) has to be replaced with the last G(s + k)(where k = (1 - overlap ratio) * F1) in Expressions (7) and (8). It should be noted that, regarding the performance of the echo removal device 1, it is desirable to set the number of frames T1 ≤ (1 - overlap ratio) * F1 such that the target value is reached within the number of frames T1.

Second Embodiment

An echo removal device 2 according to a second embodiment of the present invention is described below, mainly about differences from the first embodiment. Note that the same configurations as those in the first embodiment are denoted by the same reference signs, and descriptions thereof will be omitted in the following description.

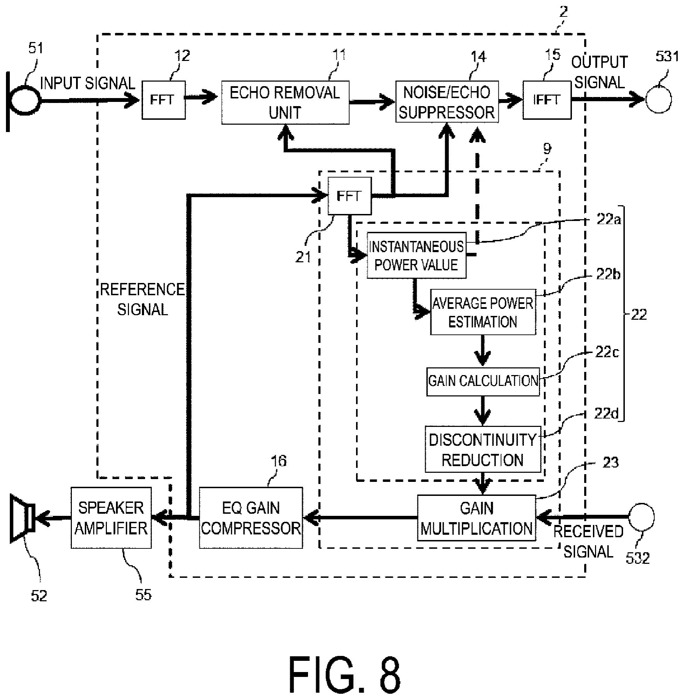

FIG. 8 is a block diagram illustrating a schematic configuration of the echo removal device 2 and the automatic gain control device 9 according to the second embodiment. Functionally, the echo removal device 2 mainly includes the automatic gain control device 9, the echo removal unit 11, the frequency analyzer (FFT unit) 12, the noise/echo suppressor 14, the restoration unit (IFFT unit) 15, and the EQ gain compressor 16. The echo removal device 2 is different from the echo removal device 1 in that the echo removal unit 11 is configured to succeed the FFT unit 12.

According to the present embodiment, echo can be eliminated with the echo removal unit 11 and the noise/echo suppressor 14 using the processing result of the FFT unit 12.

Third Embodiment

An echo removal device 3 according to a third embodiment of the present invention is described below, mainly about differences from the first embodiment. Note that the same configurations as those in the first embodiment are denoted by the same reference signs, and descriptions thereof will be omitted in the following description.

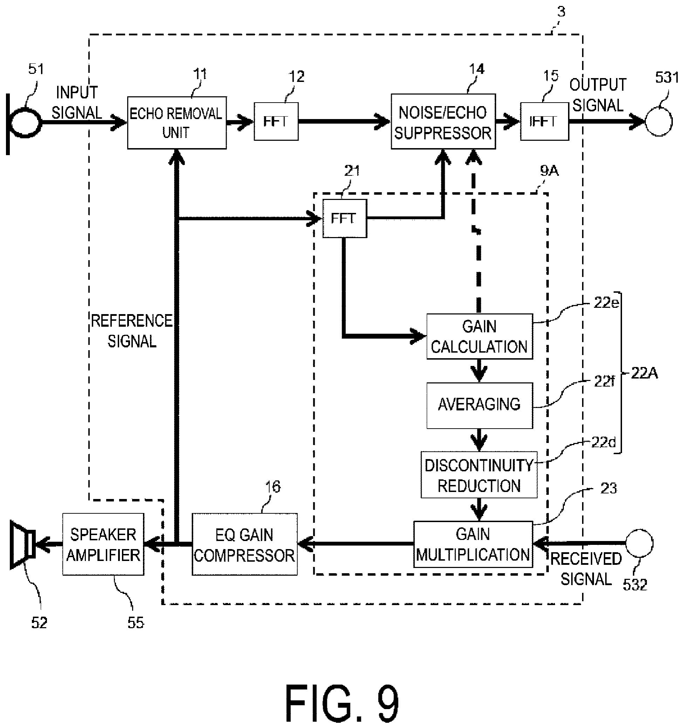

FIG. 9 is a block diagram illustrating a schematic configuration of the echo removal device 3 according to the third embodiment. Functionally, the echo removal device 3 mainly includes the automatic gain control device 9A, the echo removal unit 11, the frequency analyzer (FFT unit) 12, the noise/echo suppressor 14, the restoration unit (IFFT unit) 15, and the EQ gain compressor 16.

The automatic gain control device 9A determines the gain (corresponding to the first gain of the present invention) on the basis of the reference signal, and multiplies the received signal by this gain. Functionally, the automatic gain control device 9A mainly includes the FFT unit 21, the gain determination unit 22A, and the gain multiplication unit 23. Functionally, the gain determination unit 22 mainly includes a gain calculation unit 22e, an averaging unit 22f, and the discontinuity reduction unit 22d. The gain determination unit 22A is different from the gain determination unit 22 according to the first embodiment in that the gain calculation unit 22e is provided to precede the averaging unit 22f.

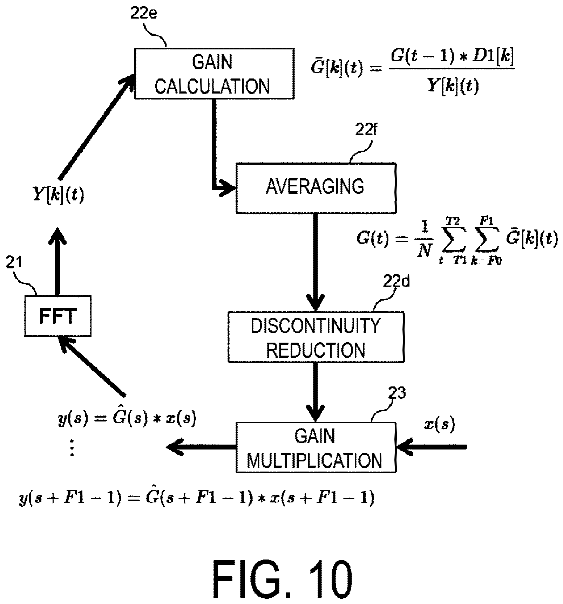

FIG. 10 is a schematic view for describing a process of the automatic gain control device 9A. In the drawing, the arrow indicates a signal flow (process flow). The EQ gain compressor 16 is not an essential component, and therefore the process of the EQ gain compressor 16 is omitted in FIG. 10.

In the gain determination unit 22A, the gain (corresponding to the first gain of the present invention) that sets the level of the output signal within a certain range is determined on the basis of the power spectrum Y[k](t) obtained at the FFT unit 21, and the received signal is multiplied by this gain at the gain multiplication unit 23.

The gain calculation unit 22e (corresponding to the second gain calculation unit of the present invention) determines the desired gain for each frequency band on the basis of the power spectrum Y[k](t). More specifically, the gain calculation unit 22e calculates the gain G[k](t) for each frequency band according to Expression (9).

[Equation 9]

$$\bar{G}[k](t) = \frac{G(t-1) * D1[k]}{Y[k](t)}$$

$$\dots (9)$$

According to Expression (10), the averaging unit 22f calculates the gain G(t) (corresponding to the second gain of the present invention) for a given frame by averaging the gain G[k](t) for each frequency over the frequency axis from F0 to F1, and over the time axis from T1 to T2.

[Equation 10]

$$G(t) = \frac{1}{N} \sum_{t=T1}^{T2} \sum_{k=F0}^{F1} \bar{G}[k](t)$$

$$\dots (10)$$

According to the present embodiment, as with the automatic gain control device 9, appropriate gain control can be performed while reducing the processing load of the processing unit. In addition, by determining the gain G(t) by averaging the gain G[k](t) for each frequency over the frequency axis from F0 to F1, and over the time axis from T1 to T2, more appropriate gain control accurately reflecting the magnitude of the reference signal can be performed.

Note that, in the present embodiment, the averaging unit 22f performs averaging first over the frequency axis and then over the time axis, but the averaging unit 22f may perform averaging first over the time axis and then over the frequency axis. In addition, the averaging unit 22f may perform weighting for each frequency. Further, the averaging unit 22f may be configured to average the gain within specific frequency bands.

Fourth Embodiment

An echo removal device 4 according to a fourth embodiment of the present invention is described below, mainly about differences from the first embodiment. This embodiment is different from the above-described embodiment in that an automatic gain control device 9B provided in the echo removal device 4 of the fourth embodiment includes a power variation detection unit 40. Note that the same configurations as those in the first embodiment are denoted by the same reference signs, and descriptions thereof will be omitted in the following description.

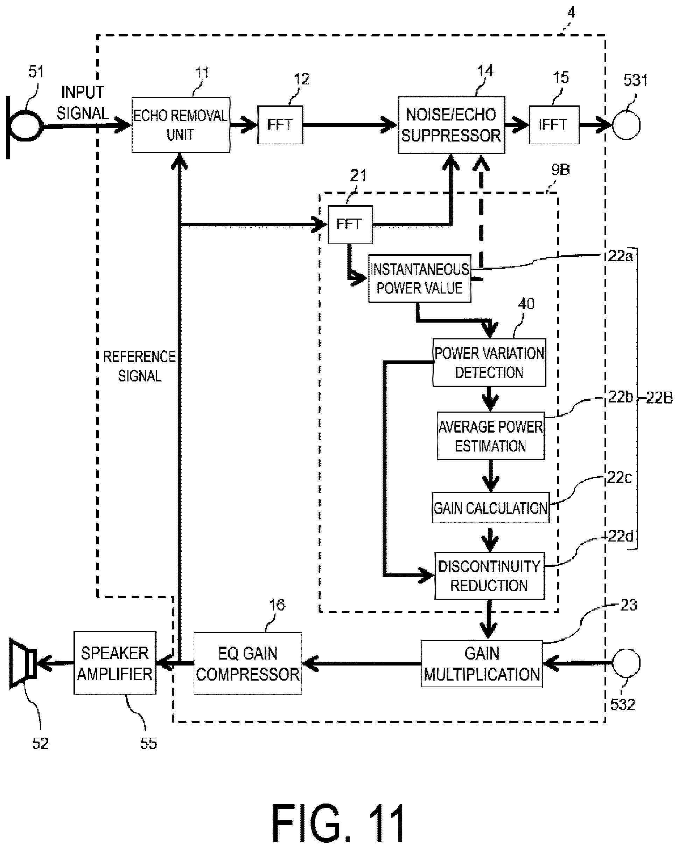

FIG. 11 is a block diagram illustrating a schematic configuration of the echo removal device 4 and the automatic gain control device 9B according to the fourth embodiment. Functionally, the echo removal device 4 mainly includes the automatic gain control device 9B, the echo removal unit 11, the frequency analyzer (FFT unit) 12, the noise/echo suppressor 14 (corresponding to the echo removal unit of the present invention), the restoration unit (IFFT unit) 15, and the EQ gain compressor 16.

The automatic gain control device 9B determines the gain on the basis of the received signal transmitted through the reception-side signal path, and multiplies the received signal by this gain. Functionally, the automatic gain control device 9B mainly includes the FFT unit 21, the gain determination unit 22B, the gain multiplication unit 23, and the power variation detection unit 40. Functionally, the gain determination unit 22B mainly includes the instantaneous power value acquisition unit 22a, the average power estimation unit 22b, the gain calculation unit 22c, and the discontinuity reduction unit 22d as with the gain determination unit 22, but is different from the gain determination unit 22 in that the power variation detection unit 40 is provided between the instantaneous power value acquisition unit 22a and the average power estimation unit 22b.

In the automatic gain control device 9B, the gain determination unit 22A and the power variation detection unit 40 determine the gain (corresponding to the first gain of the present invention) that sets the level of the output signal within a certain range on the basis of the signal processed by the FFT unit 21, and the received signal is multiplied by this gain at the gain multiplication unit 23.

The power variation detection unit 40 detects whether the rate of change of the instantaneous power value P(t) calculated by the instantaneous power value acquisition unit 22a is not smaller than a predetermined value. For example, when the positive rate of change of the instantaneous power value P(t) is equal to or greater than the threshold value, i.e., when the instantaneous power value P(t) abruptly increases, it is highly probable that the speech has started. In addition, for example, when the negative rate of change of the instantaneous power value P(t) is equal to or greater than the threshold value, i.e., when the instantaneous power value P(t) abruptly decreases, it is highly probable that unvoiced sounds, consonants, or sentence endings are being spoken during speech. Therefore, the power variation detection unit 40 detects an increase in the instantaneous power value P(t) (speech onset) and a decrease in the instantaneous power value P(t) (unvoiced sounds, consonants, or sentence endings).

When there is speech, unvoiced sounds, consonants, or sentence endings, they may cause increased errors in the instantaneous power value P(t). Therefore, when the power variation detection unit 40 detects speech, unvoiced sounds, consonants, or sentence endings, it does not change the gain and instead maintains the previous gain (G(t) = G(t - 1)). Then, the power variation detection unit 40 outputs the previous gain G(t - 1) as the gain G(t) to the discontinuity reduction unit 22d.

According to the present embodiment, when there is no speech, the processing load can be reduced by using the previous gain. In addition, by maintaining the previous gain without changing it during unvoiced sounds or sentence endings, unnecessary gain changes can be avoided, and audible voice can be ensured.

Note that, while the power variation detection unit 40 detects an increase (speech onset) in the instantaneous power value P(t) and a decrease in the instantaneous power value P(t) (unvoiced sounds, consonants, or sentence endings) in the present embodiment, the power variation detection unit 40 may detect one of the instantaneous power value P(t) and a decrease in the instantaneous power value P(t).

In addition, while the automatic gain control device 9B detects the speech on the basis of the rate of change of the power spectrum in the present embodiment, the automatic gain control device 9B may detect the presence/absence of the speech by referring to frequency characteristics or other parameters.

Fifth Embodiment

An echo removal device 5 according to a fifth embodiment of the present invention is described below, mainly about differences from the first embodiment. This embodiment is different from the above-described embodiment in that an automatic gain control device 9C provided in the echo removal device 5 of the fifth embodiment has so-called attack time and release time in gain calculation. Note that the same configurations as those in the first embodiment are denoted by the same reference signs, and descriptions thereof will be omitted in the following description.

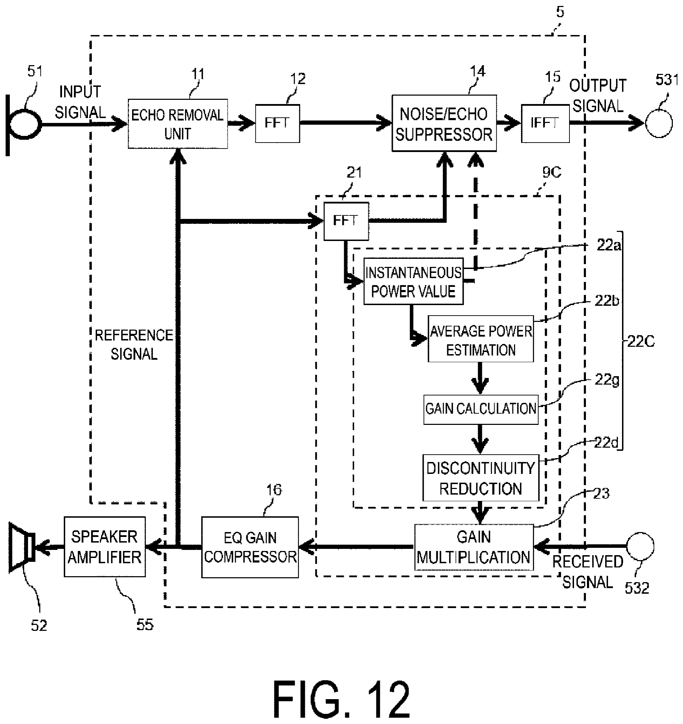

FIG. 12 is a block diagram illustrating a schematic configuration of the echo removal device 5 and the automatic gain control device 9C according to the fifth embodiment. Functionally, the echo removal device 5 mainly includes the automatic gain control device 9C, the echo removal unit 11, the frequency analyzer (FFT unit) 12, the noise/echo suppressor 14, the restoration unit (IFFT unit) 15, and the EQ gain compressor 16.

The automatic gain control device 9C determines the gain on the basis of the received signal transmitted through the reception-side signal path, and multiplies the received signal by this gain. Functionally, the automatic gain control device 9C mainly includes the FFT unit 21, the gain determination unit 22C, and the gain multiplication unit 23. On the basis of the signal processed by the FFT unit 21, the gain determination unit 22C determines the gain (corresponding to the first gain of the present invention) that sets the level of the output signal within a certain range, and the received signal is multiplied by this gain at the gain multiplication unit 23.

On the basis of the power spectrum Y[k](t) obtained by the FFT unit 21, the gain determination unit 22C calculates the gain of the output signal such that the rate of change of the gain of the output signal has a predetermined value. Functionally, the gain determination unit 22 mainly includes the instantaneous power value acquisition unit 22a, the average power estimation unit 22b, a gain calculation unit 22g, and the discontinuity reduction unit 22d.

The gain calculation unit 22g calculates the gain G(t) according to Expression (5) on the basis of the average power Ave(t) and the gain target value D1. At this time, with so-called attack time or release time, the gain calculation unit 22g gradually changes the gain G(t).

Note that, the attack time is the time required to increase the gain to the desired level when a signal is first input and the like, and the larger the attack time, the more gradually the gain increases. In addition, the release time is the time required to decrease the gain to the desired level when the gain has dropped and the like, and the larger the release time, the more gradually the gain decreases.

The attack time and release time are set in advance, and the gain calculation unit 22g retains the attack time and release time. The attack time and release time are a time period tc (corresponding to the third time period of the present invention) which is, for example, about 1 to 10 seconds, and is longer than the time period tb (corresponding to the second time period of the present invention) for the average power estimation unit 22b to calculate the average power Ave(t).

The gain calculation unit 22g changes the gain G(t) over the attack time and release time. For example, when the attack time is 10 seconds and the change in the gain G(t) is 1, the gain calculation unit 22g sets a gain G(t)' (corresponding to the second gain of the present invention) to be changed for one frame, to a value obtained by dividing 1 by the number of frames in 10 seconds.

The discontinuity reduction unit 22d inputs the G(t)' obtained by the gain calculation unit 22c to the G(t) of Expression (7) to determine the gain G(s + k) (corresponding to the first gain of the present invention).

According to the present embodiment, abrupt changes in gain can be prevented. Note that, the configuration provided with the attack time or release time is even more effective when combined with the processing by the discontinuity reduction unit 22d that reduces the discontinuity of the gain over a few frames (for example, about 0.01 to 0.1 seconds).

Sixth Embodiment

An echo removal device 6 according to a sixth embodiment of the present invention is described below, mainly about differences from the first embodiment. This embodiment is different from the above-described embodiment in that an automatic gain control device 9D provided in the echo removal device 6 of the fifth embodiment performs clipping prevention during gain multiplication. Note that the same configurations as those in the first embodiment are denoted by the same reference signs, and descriptions thereof will be omitted in the following description.

Note that, clipping refers to output of a signal with the portion exceeding the specified level cut off, and clipping can cause abnormal sounds (clipping noise).

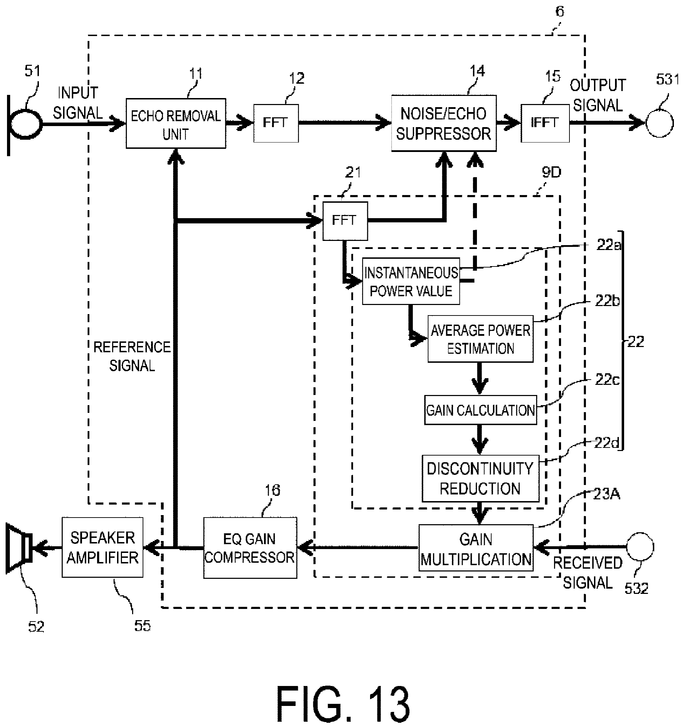

FIG. 13 is a block diagram illustrating a schematic configuration of the echo removal device 6 and the automatic gain control device 9D according to the sixth embodiment. Functionally, the echo removal device 6 mainly includes the automatic gain control device 9D, the echo removal unit 11, the frequency analyzer (FFT unit) 12, the noise/echo suppressor 14, the restoration unit (IFFT unit) 15, and the EQ gain compressor 16.

Functionally, the automatic gain control device 9D mainly includes the FFT unit 21, the gain determination unit 22, and a gain multiplication unit 23A. On the basis of the signal processed by the FFT unit 21, the gain determination unit 22 determines the gain (corresponding to the first gain of the present invention) that sets the level of the output signal within a certain range, and the received signal is multiplied by this gain at the gain multiplication unit 23A.

The gain multiplication unit 23A is provided in the reception-side signal path, and multiplies the received signal by the gain G(s + k) determined by the discontinuity reduction unit 22d. At this time, the gain multiplication unit 23A acquires the magnitude (level) of the received signal, and when the magnitude of the received signal is equal to or greater than a given threshold value, it reduces the gain to be multiplied. In addition, depending on the magnitude (level) of the received signal, the gain multiplication unit 23A may reduce the gain to 1 (stop gain multiplication).

According to the present embodiment, clipping due to excessive amplification of the signal can be prevented. In addition, damage to the device can be prevented.

The embodiments of this invention are described above in detail with reference to the drawings. However, specific configurations are not limited to the embodiments and also include changes in design or the like without departing from the gist of the invention.

Reference Signs List

1, 2, 3, 4, 5, 6 Echo removal device
9, 9A, 9B, 9C, 9D Automatic gain control device
11 Echo removal unit
12 FFT unit
14 Noise/echo suppressor
15 IFFT unit
16 EQ gain compressor
21 FFT unit
22, 22A, 22B, 22C Gain determination unit
22a Instantaneous power value acquisition unit
22b Average power estimation unit
22c, 22e, 22g Gain calculation unit
22d Discontinuity reduction unit
22f Averaging unit
23, 23A Gain multiplication unit
40 Power variation detection unit
50 Terminal
51 Microphone

52 Speaker
53 Communication device
54 Communication device
55 Speaker amplifier
100 Voice communication system
531 Output unit
532 Input unit

## Claims

1. An automatic gain control device comprising:

   a frequency domain conversion unit configured to convert a first input signal of a time domain into a second input signal of a frequency domain, the first input signal being a reference signal that is input in a first time period from a reception-side signal path through which a received signal is transmitted to a speaker provided in a terminal;
   a gain determination unit configured to calculate a first gain based on the second input signal; and
   a gain multiplication unit provided in the reception-side signal path, and configured to multiply the received signal by the first gain,
   wherein
   the reference signal is a signal after the received signal is multiplied by the first gain at the gain multiplication unit.

2. The automatic gain control device according to claim 1, wherein
   the gain determination unit includes:

   an instantaneous power value acquisition unit configured to calculate an instantaneous power value based on the second input signal, the instantaneous power value being an instantaneous value of power of the reference signal;
   an average power estimation unit configured to calculate an average power of a numerical representation of an estimated value of a magnitude of sound that drives the speaker based on a plurality of the instantaneous power values determined by the instantaneous power value acquisition unit in a second time period that is longer than the first time period;
   a gain calculation unit configured to calculate a desired second gain based on the average power and a gain target value; and
   a discontinuity reduction unit configured to calculate the first gain based on the second gain, and set a rate of change of the first gain within a predetermined range.

3. The automatic gain control device according to claim 1, wherein
   the gain determination unit includes:

   a second gain calculation unit configured to calculate a third gain for each frequency band based on the second input signal and a target value of a gain;
   an averaging unit configured to calculate a second gain by averaging, in a frequency direction and a time direction, the third gain calculated in a second time period that is longer than the first time period; and
   a discontinuity reduction unit configured to calculate the first gain based on the second gain, and set a rate of change of the first gain within a predetermined range.

4. The automatic gain control device according to claim 2 or 3, wherein the discontinuity reduction unit operates such that discontinuity of the first gain occurs at a zero-crossing point where an amplitude variation of the reference signal reverses.

5. The automatic gain control device according to claim 2 or 3, wherein the discontinuity reduction unit gradually changes the first gain in a range up to a maximum point where an amplitude variation of the reference signal is maximized.

6. The automatic gain control device according to claim 2, further comprising a power variation detection unit configured to detect a fact that a rate of change of the instantaneous power value is equal to or greater than a predetermined value,
   wherein

when the rate of change of the instantaneous power value is detected to be equal to or greater than the predetermined value, the gain determination unit does not change the first gain.

7. The automatic gain control device according to any one of claims 2 to 6, wherein the gain determination unit changes the second gain over a third time period that is longer than the second time period.

8. The automatic gain control device according to any one of claims 1 to 7, wherein when a magnitude of the received signal is equal to or greater than a threshold value, the gain multiplication unit reduces the first gain.

9. An echo removal device comprising:

the automatic gain control device described in any one of claims 1 to 8; and
an echo removal unit provided in a transmission-side signal path through which an input signal input from a microphone provided in the terminal is transmitted, the echo removal unit being configured to remove echo that is generated when a voice output from the speaker is input to the microphone,
wherein
the echo removal unit removes echo based on the second input signal converted by the frequency domain conversion unit.

10. An automatic gain control method comprising:

converting a first input signal of a time domain into a second input signal of a frequency domain, the first input signal being a reference signal that is input in a first time period from a reception-side signal path through which a received signal is transmitted to a speaker provided in a terminal;
calculating a first gain based on the second input signal; and
multiplying the received signal by the first gain, the multiplying being provided in the reception-side signal path, wherein
the reference signal is a signal after the received signal is multiplied by the first gain.

11. An automatic gain control program configured to cause a computer to function as:

a frequency domain conversion unit configured to convert a first input signal of a time domain into a second input signal of a frequency domain, the first input signal being a reference signal that is input in a first time period from a reception-side signal path through which a received signal is transmitted to a speaker provided in a terminal;
a gain determination unit configured to calculate a first gain based on the second input signal; and
a gain multiplication unit provided in the reception-side signal path, and configured to multiply the received signal by the first gain,
wherein
the reference signal is a signal after the received signal is multiplied by the first gain at the gain multiplication unit.

**FIG. 1**

FIG. 2

EP 4 693 899 A1

22a

INSTANTANEOUS POWER VALUE $\qquad P(t) = \sum_{k\ F0}^{F1} (A[k] * Y[k](t))$

$Y[k](t)$

22b

AVERAGE POWER ESTIMATION $\qquad Ave(t) = \sum_{t\ T1}^{T2} P(t)$

21

FFT

22c GAIN CALCULATION $\qquad G(t) = \dfrac{G(t-1) * D1}{Ave(t)}$ D1: TARGET VALUE

22d DISCONTINUITY REDUCTION $\qquad \hat{G}(s+k) = \dfrac{G(t) - G(t-1)}{T1 + 1} * (k+1) + G(t-1) \quad k = 0, 1 \cdots T1 - 1$

or

$\hat{G}(s+k) = \dfrac{G(t-1) - G(t)}{(1 - T1)^2} * (k - T1 + 1)^2 + G(t) \quad k = 0, 1 \cdots T1 - 1$

$y(s) = \hat{G}(s) * x(s)$
⋮

23

GAIN MULTIPLICATION $\qquad x(s) \quad \cdots$

$y(s + F1 - 1) = \hat{G}(s + F1 - 1) * x(s + F1 - 1)$

## FIG. 3

FREQUENCY (Hz)

WEIGHTING RANGE OF C-WEIGHTING

WEIGHTING RANGE OF A-WEIGHTING

WEIGHTING RANGE
OF Z-WEIGHTING

Z-WEIGHTING

C-WEIGHTING

CORRECTION
VALUE (dB)

A-WEIGHTING

FIG. 4

APPROACH G(0) OVER T1

G(0)          G(1)

S=0                                              TIME AXIS

| x(0) to x(F1 - 1) |

| Y[k](0) |

OVERLAP RATIO

| x(a) to x(a + F1 - 1) |

| Y[k](1) |

# FIG. 5

(a) REFERENCE SIGNAL

ZERO-CROSSING POINT

$\hat{G}(s+k)$

(b) GAIN

$\hat{G}(s+k)$

(c) GAIN

FIG. 6

FIG. 7

FIG. 8

FIG. 9

$$\bar{G}[k](t) = \frac{G(t-1) * D1[k]}{Y[k](t)}$$

$$G(t) = \frac{1}{N} \sum_{t}^{T2} \sum_{T1}^{F1} \sum_{k}^{F1} \bar{G}[k](t)$$

$$y(s) = \hat{G}(s) * x(s)$$

$$y(s + F1 - 1) = \hat{G}(s + F1 - 1) * x(s + F1 - 1)$$

FIG. 10

FIG. 11

FIG. 12

FIG. 13

## INTERNATIONAL SEARCH REPORT

| International application No. |
|---|
| **PCT/JP2023/046903** |

**A.    CLASSIFICATION OF SUBJECT MATTER**

*H03G 3/20*(2006.01)i; *G10L 21/034*(2013.01)i; *H04B 3/23*(2006.01)i
FI:    H03G3/20 A; G10L21/034; H04B3/23

According to International Patent Classification (IPC) or to both national classification and IPC

**B.    FIELDS SEARCHED**

Minimum documentation searched (classification system followed by classification symbols)

H03G3/20; G10L21/034; H04B3/23

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | US 2012/0206195 A1 (DIALOG SEMICONDUCTOR B. V.) 16 August 2012 (2012-08-16) paragraphs [0002], [0093]-[0138], fig. 6-8, 11, 14c, 17 | 1-2, 5-6, 10-11 |
| Y | | 4, 7-9 |
| A | | 3 |
| Y | JP 2014-192585 A (ASAHI KASEI EMD CORPORATION) 06 October 2014 (2014-10-06) paragraphs [0037]-[0045], [0052]-[0054]. fig. 4, 7, 8 | 4, 7-9 |
| A | | 3 |
| A | US 2009/0225980 A1 (SCHMIDT, Gerhard uwe) 10 September 2009 (2009-09-10) entire text, all drawings | 1-11 |

☐ Further documents are listed in the continuation of Box C.          ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 March 2024** | **19 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2023/046903**

| Patent document cited in search report | | | Publication date (day/month/year) | Patent family member(s) | | | Publication date (day/month/year) |
|---|---|---|---|---|---|---|---|
| US | 2012/0206195 | A1 | 16 August 2012 | EP 2487792 A1 paragraphs [0001], [0043]-[0067], fig. 6-8, 11, 14c, 17 | | | |
| JP | 2014-192585 | A | 06 October 2014 | (Family: none) | | | |
| US | 2009/0225980 | A1 | 10 September 2009 | EP 2048659 A1 entire text, all drawings | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004129187 A